# EUROPEAN PATENT SPECIFICATION

(11) **EP 4 477 994 B1**
(45) Date of publication and mention of the grant of the patent: **28.10.2026**
(21) Application number: 23178963.7
(22) Date of filing: 13.06.2023
(51) Int. Cl.: G01B 11/26, H05K 13/04, H05K 13/08

(54) **SYSTEM AND METHOD FOR DETERMINING AN ORIENTATION OF A PICKUP UNIT OF A PICK-AND-PLACE APPARATUS**
SYSTEM UND VERFAHREN ZUR BESTIMMUNG EINER AUSRICHTUNG EINER AUFNAHMEEINHEIT EINER BESTÜCKUNGSMASCHINE
SYSTÈME ET MÉTHODE DE DÉTERMINATION D'UNE ORIENTATION D'UNE UNITÉ DE PRÉHENSION D'UN APPAREIL DE PLACEMENT

(43) Date of publication of application: 18.12.2024
(73) Proprietor: Nexperia B.V., 6534 AB Nijmegen (NL)
(72) Inventor: Liu, Yazhao, The Hague (NL); Goosen, Johannes Frans Lodewijk, Delft (NL); van der Veen, Gijs, Nijmegen (NL)
(74) Representative: Pjanovic, Ilija

(56) References cited:
- JP-B2- 5 322 099
- US-A1- 2008 002 197
- US-B1- 6 400 459

## Description

### FIELD

Aspects of the present disclosure relate to a pick-and-place apparatus comprising a pickup unit and a system for determining an orientation of the pickup unit, and a method for determining an orientation of the pickup unit.

### BACKGROUND

Pick-and-place apparatuses are known devices by which an electronic component can be picked from a first carrier and can be placed onto a second carrier. An exemplary application of a pick-and-place apparatus is to pick semiconductor dies from a semiconductor wafer and to place the picked semiconductor dies onto a printed circuit board. In this case, the semiconductor wafer or carrier that supports it is the first carrier and the printed circuit board the second carrier.

Typically, the pick-and-place apparatus comprises a pickup unit by which the electronic components are picked. This same unit, or another unit, may be used for placing the picked electronic components onto the second carrier.

A known pickup unit uses a vacuum force for picking up electronic components. In these units, the electronic components are sucked against a nozzle or tip. For placing the electronic components onto the second carrier, the vacuum is removed and/or gas is expelled through the nozzle or tip to push the electronic component away from the pickup unit.

When arranging electronic components using the pickup unit as described above, a problem may exist in that the force by which the electronic component is arranged onto the second carrier is not constant during the process of arranging a plurality of electronic components. Typically, an adhesive or other material by which the electronic component is fixedly and electrically attached to the printed circuit board, such as solder, is arranged onto the second carrier in predefined quantities. When pressing the electronic component into or onto the adhesive, some of the adhesive, which may be in an at least partially liquid form when arranging the electronic components, may flow out from underneath the electronic component. The amount of flow-out, and therefore the amount of adhesive that remains underneath the electronic component, depends inter alia on the force by which the electronic components are arranged onto the second carrier. Consequently, when this force is not constant, variations may occur in the amount of adhesive that is arranged in between the electronic components and the second carrier. This will introduce a variation in the height position of the electronic components over the second carrier. For some applications, such as a printed circuit board provided with a matrix of LEDs, a variation of this sort is unwanted.

In addition to the variation in the height position of the electronic components, a variation in the orientation of the electronic components relative to the second carrier may occur.

Pickup units are generally moving devices subject to variation in position and orientation. For example, the position at which a pickup unit may place an electronic component may be slightly different from an intended position. Similarly, the orientation in which a pickup unit may place an electronic component may be slightly different from an intended orientation. These variations may also be unwanted. Similar problems may occur when arranging electronic components onto the second carrier.

US 6,400,459 B1 shows a pick-and-place apparatus comprising an optical sensor for determining the angular orientation and the vertical position of a pickup unit.

Determining the orientation and position of the pickup unit is generally complicated due to the large number of components in the pick-and-place apparatus. Furthermore, as the pickup unit is moving during operation, some known techniques for determining the orientation and/or position of the pickup unit cannot be used.

### SUMMARY

According to aspects of the present disclosure, a pick-and-place apparatus is provided in which the abovementioned problems are addressed.

According to a first aspect of the present invention, which is defined in claim 1, a pick-and-place apparatus is provided for picking an electronic component from a first carrier and for placing the component onto a second carrier. This apparatus comprises a pickup unit for picking up an electronic component and for placing that electronic component. The apparatus further comprises a system for determining an orientation of the pickup unit, wherein a diffraction grating is arranged on a surface of the pickup unit.

This system comprises a collimated light source configured for emitting collimated light onto the diffraction grating thereby creating, by means of diffraction by the diffraction grating, an *m-th* order light beam and an n-th order light beam, wherein *m* is different from *n.*

It is known that diffraction gratings, once irradiated with a beam of collimated light, may generate different light beams travelling in different directions. The relationship between the angle of the incoming beam of collimated light relative to the grating normal, *θᵢ*, and the angle of an *m*-th order light beam leaving the diffraction grating, *θₘ*, is given, for a transmissive diffraction grating by: $d \left({sinθ}_{m}-{sinθ}_{i}\right) = mλ$ Eq. 1 wherein both *θᵢ* and *θₘ* are positive if the incident and diffracted beams are on opposite sides of the grating surface normal, and wherein *m* is the diffraction order, ..-2,-1,0, +1, +2, .., wherein *λ* is the wavelength of the incoming collimated light, and wherein d is a characteristic size of the diffraction grating, which should be larger than *λ*. If the incident and diffracted beams are on the same side of the grating normal, *θₘ* must be considered negative.

For a reflective diffraction grating, the relationship equals: $d \left({sinθ}_{m}+{sinθ}_{i}\right) = mλ$ Eq. 2 wherein *θᵢ* is positive and *θₘ* is negative if the incident and diffracted beams are on opposite sides of the grating surface normal. If the beams are on the same side of the grating surface normal, then both angles are considered positive.

If the diffraction grating comprises a plurality of regularly arranged slits, *d* represents the distance from the center of one slit to the center of the directly adjacent slit. Within the context of the present disclosure, the different diffraction orders are referred to using the integer *m* in equations 1 and 2 above.

It should be noted that many different diffraction gratings are known in the art that comply with equations 1 and 2 above. The present disclosure is not limited to a particular form of diffraction grating.

The system according to the first aspect of the present disclosure further comprises a first light sensor having a first sensor surface. The first light sensor is configured for detecting the *m*-th order light beam. More in particular, the first light sensor is configured for detecting a first position on the first sensor surface at which the *m*-th order light beam is detected. Similarly, the pick-and-place apparatus further comprises a second light sensor having a second sensor surface. The second light sensor is configured for detecting the n-th order light beam. More in particular, the second light sensor is configured for detecting a second position on the second sensor surface at which the n-th order light beam is detected, wherein *m* is different from *n,* and wherein *m* and *n* are both integers different from zero. Preferably *m*=-*n,* and *m* is preferably equal to 1.

The pick-and-place apparatus further comprises a processor for determining orientation information concerning an orientation of the pickup unit based on the detected first position and the detected second position.

To this end, the diffraction grating is preferably at least locally flat and perpendicular to a first direction at a center point of the diffraction grating. Furthermore, the diffraction grating may comprise a repetition of a pattern unit from the center point in a second direction and from the center point in a direction opposite to the second direction. The pattern unit at the center point can be elongated in a third direction. For example, the pattern unit may correspond to a slit elongated in the third direction and having a width *d*/2 in the second direction. On both sides of the slit, elongated stripes or slats of width *d*/4 are arranged. Repeating this pattern unit in the second direction, and the direction opposite to the second direction, will produce a regular pattern in which a distance between centers of adjacent slits equals *d.*

The collimated light source can be configured to emit a collimated beam of light towards the center point of the diffraction grating. Furthermore, the pickup unit may be configured to change its orientation by means of yawing relative to a yaw rotational axis, tilting relative to a tilt rotational axis, and rolling relative to a roll rotational axis. The orientation information of the pickup unit may comprise a yaw angle, a tilt angle, and a roll angle. With the pickup unit being oriented in a predetermined default orientation, the yaw rotational axis may extend in the third direction, the tilt rotational axis may extend in the second direction, and the roll rotational axis may extend in the first direction.

The processor may be configured to determine the orientation of the pickup unit based on the assumption that a) the center point of the diffraction grating remains at a fixed position in space, b) a predetermined center point of the pickup unit remains at a fixed position in space, or c) both the center point of the diffraction grating and the center point of the pickup unit are not fixed in space.

Which assumption among assumptions a), b), and c) applies may be determined by mechanical constraints. For example, movement of the pickup unit may be mechanically limited to any of the assumptions mentioned above. Furthermore, in some cases, differences in the determined orientation information between assumptions a) and b) may be small. In such cases, the orientation information can be calculated based on assumption a) even though the actual movement of the pickup unit is in accordance with assumption b). This may for example occur if the center point of the diffraction grating substantially coincides with the predetermined center point of the pickup unit. Such a situation may occur when the pickup unit is relatively flat in the first direction.

When the movement of the pickup unit is in accordance with assumption a), the processor may determine the orientation information based on the detected first position and the detected second position.

When the movement of the pickup unit is in accordance with assumption b), the processor may determine the orientation of the pickup unit based on the detected first position, the detected second position, and a known positional relationship between center point of the diffraction grating and the predetermined center point of the pickup unit.

The system may further comprise a third light sensor having a third sensor surface, wherein the third light sensor is configured for detecting a 0-th order light beam. More in particular, the third light sensor can be configured for detecting a third position on the third sensor surface at which the 0-th order light beam is detected.

When the movement of the pickup unit is in accordance with assumption c), the processor may determine the orientation of the pickup unit based on the detected first position, the detected second position, and the detected third position. In this latter case, the collimated light source should have a known orientation and position relative to the first, second, and third light sensors.

It should be noted that the latter computational method for determining the orientation and position of the pickup unit could equally be used when the movement of the pickup unit is in accordance with assumption a) or b).

The processor can be configured to control an orientation of the collimated light source. For example, the device may comprise a processor-controlled orientation unit for changing an orientation of the light source. Furthermore, the processor may implement a feedback control loop in which the orientation of the light source is changed based on a determined position and/or orientation of the pickup unit to ensure that the collimated light source keeps emitting collimated light onto the center point of the diffraction grating. This is particularly relevant if the device moves in accordance with assumptions b) or c).

The first and second sensors, and if applicable the third sensor, may have a fixed and known position and orientation. Furthermore, the collimated light source may be a coherent light source, such as a laser, of which the orientation is known and/or can be determined. The position and orientation information of the light source and/or of the first, second, and/or third sensor may be used by the processor when determining the position and orientation of the pickup unit.

The system may further comprise a memory that is operatively coupled to the processor. The memory may comprise a lookup table comprising data that correlates position data obtained from the first, second, and optionally third sensor, to orientation and/or position information of the pickup unit.

Use of a lookup table reduces computational effort and time for determining the orientation and position information.

The first sensor, second sensor, and optionally third sensor may be substantially flat sensors. Alternatively, the first sensor, second sensor, and optionally third sensor could be curved sensors of which each point on the corresponding sensor surface has a substantially identical distance to a common reference point. In so far the movement of the device is in accordance with assumption a) the common reference point may substantially coincide with the center point of the diffraction grating. Furthermore, the first sensor, second sensor, and optionally third sensor could be different parts of a single integral sensor.

The diffraction grating can either be a reflective or transmissive grating.

According to a second aspect of the present invention, which is defined in claim 14, a method for determining an orientation of a pickup unit of a pick and place apparatus for picking an electronic component from a first carrier and for placing the electronic component into a second carrier is provided, wherein a surface of the pickup unit is provided with a diffraction grating. The method comprises the steps of i) emitting collimated light onto the diffraction grating thereby creating, by means of diffraction by the diffraction grating, an m-th order light beam and an n-th order light beam, wherein *m* is different from *n,* and wherein *m* and *n* are both integers different than zero, ii) detecting, using a first light sensor having a first sensor surface, the *m*-th order light beam, said detecting comprising detecting a first position on the first sensor surface at which the *m*-th order light beam is detected, iii) detecting, using a second light sensor having a second sensor surface, the *n*-th order light beam, said detecting comprising detecting a second position on the second sensor surface at which the *n*-th order light beam is detected, and iv) determining, using a processor, an orientation of the pickup unit based on the detected first position and the detected second position.

### DESCRIPTION OF THE DRAWINGS

So that the manner in which the features of the present disclosure can be understood in detail, a more particular description is made with reference to embodiments, some of which are illustrated in the appended figures. It is to be noted, however, that the appended figures illustrate only typical embodiments and are therefore not to be considered limiting of its scope. The figures are for facilitating an understanding of the disclosure and thus are not necessarily drawn to scale. Advantages of the subject matter claimed will become apparent to those skilled in the art upon reading this description in conjunction with the accompanying figures, in which like reference numerals have been used to designate like elements, and in which:
Figure 1 illustrates a transmissive diffraction grating (top) and reflective diffraction grating (bottom);
Figure 2 schematically illustrates a pick-and-place apparatus in accordance with the present disclosure;
Figure 3 illustrates an embodiment of a pick-and-place apparatus in accordance with the present disclosure;
Figures 4A-4D illustrate different detailed views of the apparatus of figure 3;
Figure 5 illustrates a mold for making the pickup unit of the apparatus of figure 3;
Figure 6 illustrate the various rotations to be determined by the system of figure 2; and
Figure 7 illustrates a method by which the angle of a light beam can be detected in accordance with an aspect of the present disclosure.

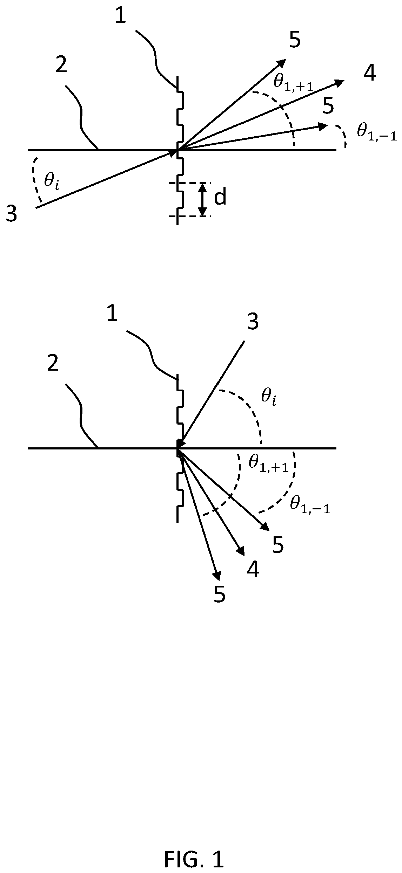

Figure 1 illustrates a transmissive (top) and reflective (bottom) diffraction grating pattern. In both cases, a collimated light beam 3 is incident on a diffraction grating 1 at an angle *θᵢ* with respect to normal 2. Due to diffraction, higher order light beams 5 are generated in addition to a 0-th order light beam 4.

In figure 1, two higher order light beams are illustrated, namely two first-order light beams that make an angle with normal 2 of *θₘ* = *θ*_{1,+1} and *θₘ* = *θ*_{1,-1}. Both angles comply with equation 1, which for the transmissive and reflective diffraction gratings results in: ${sinθ}_{1 , + 1} = {sinθ}_{i} + \frac{λ}{d}$ Eq. 3 ${sinθ}_{1 , - 1} = {sinθ}_{i} - \frac{λ}{d}$ Eq. 4

It can be seen that if distance *d* changes, so will the angles *θ*_{1,+1} and *θ*_{1,-1}. Furthermore, if the diffraction grating changes orientation, light beams corresponding to the +1-th and -1-th order will change the paths along which they propagate through space. According to an aspect of the present disclosure, by arranging a diffraction grating on a device, it becomes possible to monitor the orientation and length change of the device. The Applicant has realized that this particular manner of monitoring is particularly effective in pick-and-place apparatuses in which electronic components are to be picked and placed with great accuracies. Furthermore, such a contactless measurement technique is particularly useful when inspecting the pickup units.

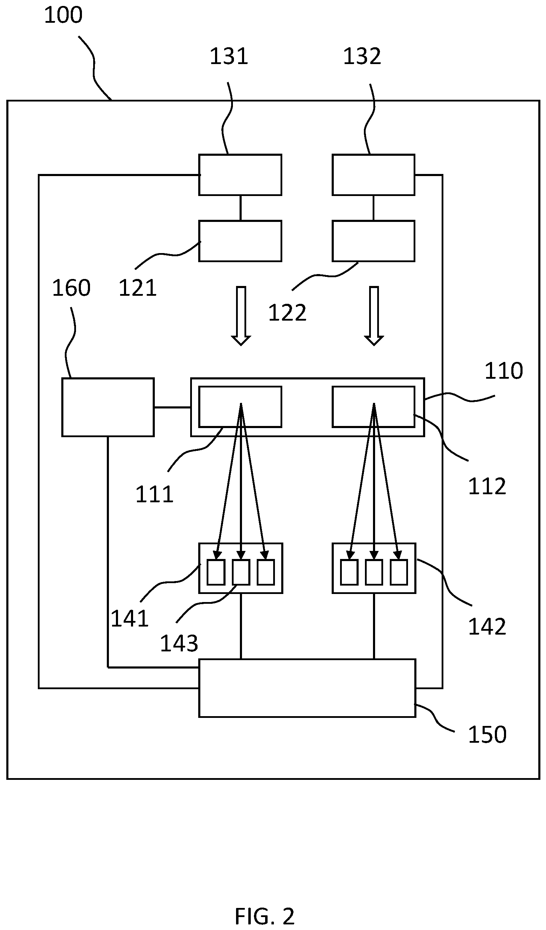

Figure 2 schematically illustrates a pick-and-place apparatus 100 in accordance with the present disclosure. The abovementioned device may for example correspond to a pickup unit of this pick-and-place apparatus.

Apparatus 100 comprises a pickup unit 110, wherein an outer surface of pickup unit 110 is provided with a first diffraction grating 111 and a second diffraction grating 112. Each pattern 111, 112 comprises a repetition of a respective pattern unit. The pattern units for diffraction gratings 111, 112 may differ from each other. For example, the characteristic distance *d* and/or the construction of diffraction gratings 111, 112 may differ. Furthermore, the direction in which the pattern units are repetitively arranged may be different for patterns 111, 112.

Apparatus 100 further comprises a first collimated light source 121 and a second collimated light source 122 of which the orientation may be changed using respective orientation units 131, 132.

Apparatus 100 comprises respective sensor systems 141, 142 for sensing the light beams from diffraction gratings 111, 112, respectively. Each sensor system 141, 142 comprises three sensors 143, one for sensing the 0-th order, one for sensing the +1-th order, and one for sensing the -1-th order.

Apparatus 100 comprises a processor 150 configured for processing the signals from sensor systems 141, 142. Processor 150 controls a movable support unit 160 on which pickup unit 110 is mounted.

Processor 150 may form, together with collimated light sources 121, 122, and sensor systems 141, 142, a system for determining an orientation of pickup unit 110 as will be explained below. Furthermore, more light sources and sensor systems may be provided, for example for determining orientation, position, and/or length change of pickup unit 110 at various positions in apparatus 100, for example at a position at which electronic components are picked from a first carrier, or a position at which electronic components are placed onto a second carrier. In addition, embodiments are possible in which less or more diffraction gratings are used on the surface of pickup unit 110.

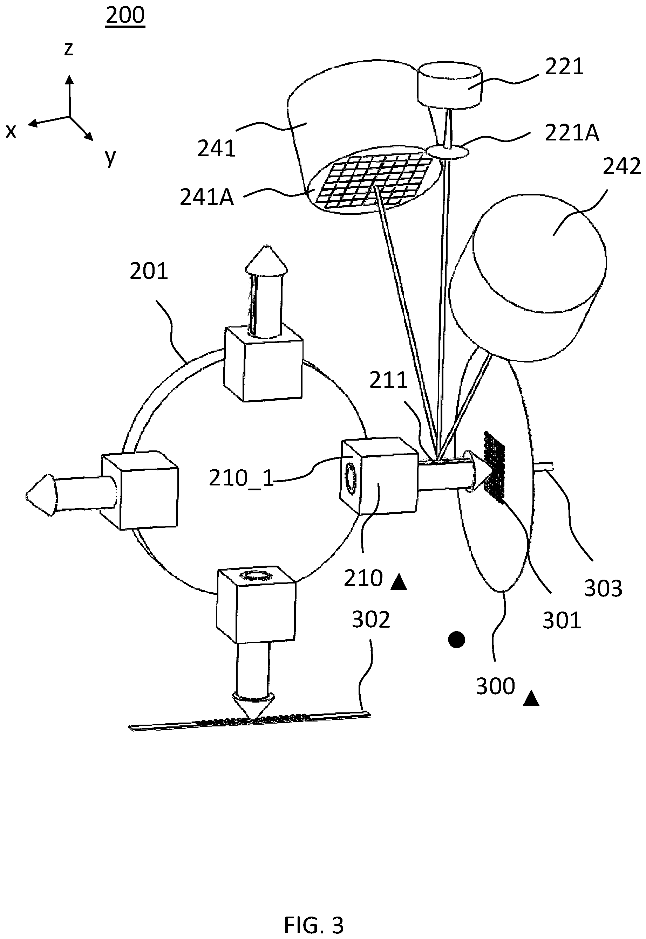

Figure 3 illustrates an embodiment of a pick-and-place apparatus 200 in accordance with the present disclosure. It comprises carousel 201 on which four pickup units 110 are mounted. Also shown is a semiconductor wafer 300 comprising a plurality of semiconductor dies 301 that are to be arranged onto a second carrier 302. Semiconductor wafer 300 is arranged on a film or foil and is further supported by a stage (not shown) that is capable of being moved in directions z, y shown in figure 3. In this case, the film or foil, or the film frame carrier to which the film or foil is connected acts as a first carrier. Similarly, second carrier 302 is supported by a stage (not shown) that is capable of being moved in directions x, y shown in figure 3. To move the abovementioned stages, suitable electric motors can be used.

The process of picking and placing semiconductor dies 301 will be explained next.

To pick up a semiconductor die 301 from wafer 300, the stage supporting semiconductor wafer 300 is moved to bring a next semiconductor die on wafer 300 into alignment with pickup unit 210_1.

To pick up semiconductor die 301, pickup unit 210 and wafer 300 are moved towards each other. This can be achieved by driving pickup unit 210 to move in a direction opposite to the x-direction, for example using movable support unit 160 shown in figure 2, and/or by moving the stage that supports semiconductor wafer 300 in the x-direction.

A needle like element 303 is provided at the backside of semiconductor wafer 300. This element can be moved in the x-direction causing it to punch or push onto the foil thereby resulting in the semiconductor die 301 at this position at least partially detaching from a remainder of wafer 300.

Pickup unit 210 is provided with a tip through which a suction force can be exerted. As a result of this force, semiconductor die 301 becomes attached to the tip of pickup unit 210. Next, carousel 201 is rotated clockwise to bring the semiconductor die 301 that was picked up last into alignment with second carrier 302. Typically, a second carrier 302 is provided with discrete spots of adhesive, such as solder. Using the stage supporting second carrier 302, second carrier 302 is moved to bring an empty position on second carrier 302 into alignment with pickup unit 210. Once in alignment, pickup unit 210 and second carrier 302 are moved towards each other in the z-direction. Again, this movement can be achieved by moving pickup unit 210 and/or by moving second carrier 302. When pickup unit 210 is sufficiently close to second carrier 302, the suction force in the tip of pickup unit 210 is removed and/or pressure is applied to the tip to push semiconductor die 301 away from the pickup unit. It should be noted that while a semiconductor die is arranged on second carrier 302, a new semiconductor die can be picked from semiconductor wafer 300. This is possible thanks to the arrangement of multiple pickup units 210 on carousel 201.

During the picking and placing process, pickup unit 210 may physically contact a semiconductor die 301. For example, pickup unit 210 may contact the semiconductor die before it is picked. In this case, the semiconductor die is arranged in between pickup unit 210 on one side and the foil and needle like element 303 on the other side. Similarly, during placing of semiconductor die 301, pickup unit 210 may push semiconductor die 301 against second carrier 302.

To enable a uniform pick-and-place process, the force that pickup unit 210 exerts a force onto semiconductor dies 301 is ideally constant throughout the process, and from wafer to wafer. Similarly, the orientation of pickup unit 210 is preferably constant and/or known. To this end, pick-and-place apparatus 200 can be provided with a system for determining an orientation of pickup unit 210. This system uses a diffractive grating 211 that is arranged on an outer surface of pickup unit 210. A collimated light source comprising a light source 221 and collimating lens 221A generates a collimated beam of light that impinges diffraction grating 211 perpendicularly. The +1-th order light beam and the -1-th order light beam that are generated by diffraction grating 211 are sensed using light sensors 241, 242 that each comprise a sensor surface 241A. More particularly, light sensors output coordinates on sensor surface 241A at which a light beam is detected.

In figure 3, pick-and-place apparatus 200 comprises a single carousel 201. Consequently, semiconductor dies 301 are picked and arranged from the same side and using the same pickup unit. In some applications, the orientation of semiconductor 301 should be flipped in between picking semiconductor dies 301 and placing semiconductor dies 301. Examples are flip-chip applications.

Flipping the orientation of semiconductor dies 301 can be achieved using a second carousel that is arranged next to carousel 201. The second carousel will then receive semiconductor dies 301 from carousel 201. More in particular, pickup units on the second carousel, which are similar to those on carousel 201, will receive semiconductor dies 301 from carousel 201. The pickup units on the second carousel will then perform the final placing of semiconductor dies 301 on the second carrier 302.

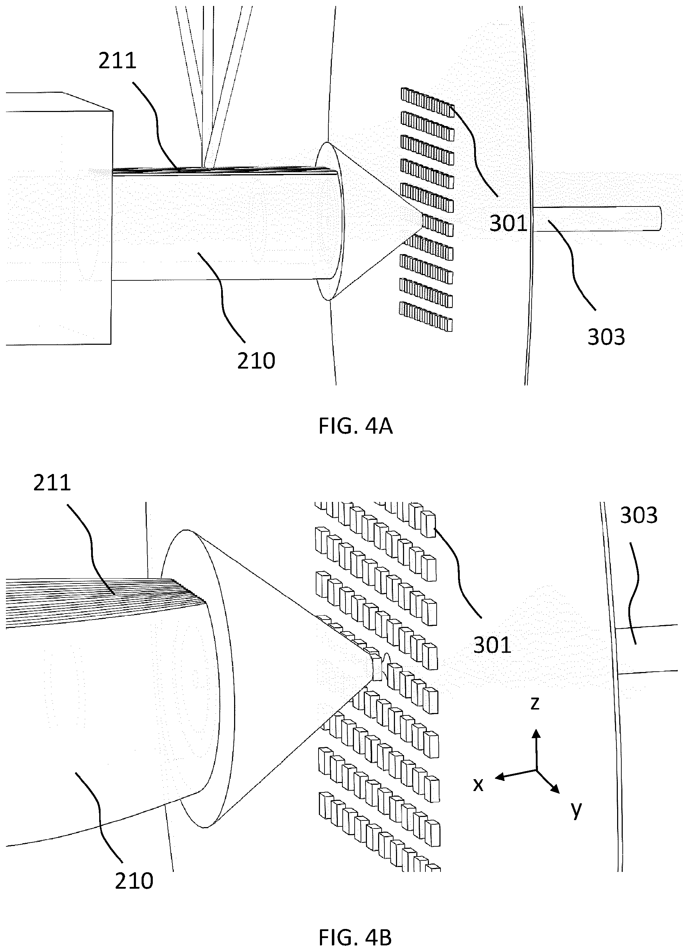

A processor, such as processor 150 in figure 2, is used for collecting the data from sensors 241 and 242, and for determining a change in length at the position at which the collimated light beam impinges on diffraction grating 211. This is shown in more detail in figures 4A-4D.

As shown in figure 4B, pickup unit 210 contacts semiconductor die 301, for example because it is pushed towards pickup unit 201 by needle like element 303. The force exerted on pickup unit 210 will cause the latter to deform.

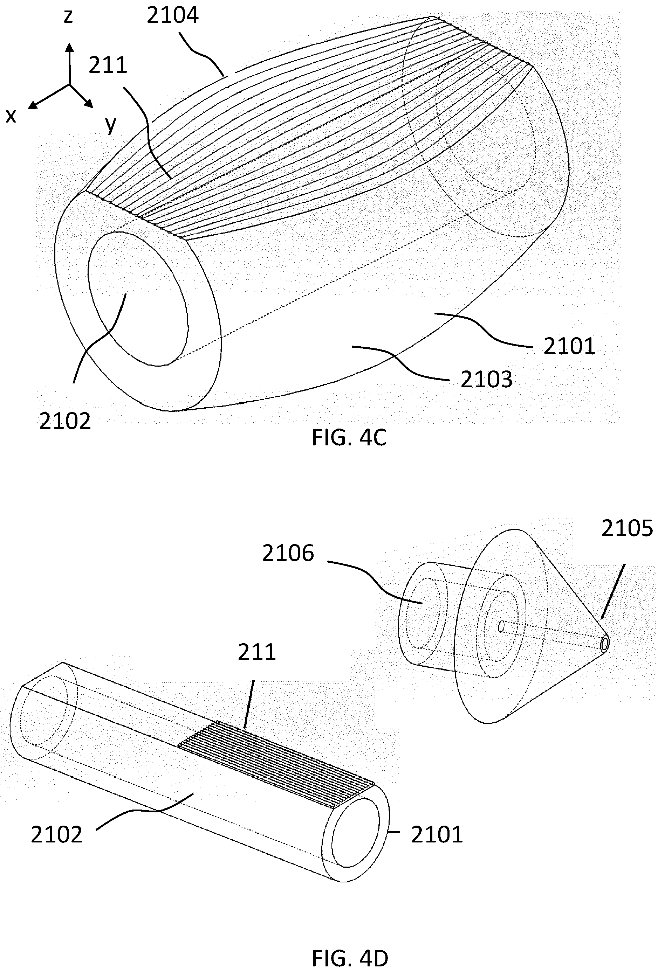

Pickup unit 210 is shown in more detail in figures 4C and 4D. Pickup unit 210 comprises a deformable shaft 2101 having a central bore 2102. An outer surface 2103 of pickup unit 210 comprises a flat portion 2104 at which it is provided with diffraction grating 211. This pattern comprises a plurality of pattern units that are elongated in the x-direction and which are repeated in the y-direction. It is noted that figure 4C illustrates elongated shaft 2101 and diffraction grating 211 in a deformed state.

Pickup unit 210 further comprises tip 2105 that is provided with a central bore 2106. Tip 2105 is typically fastened or attached to shaft 2101 such that central bore 2102 and central bore 2106 are aligned. By reducing pressure inside central bore 2101, a suction force can be generated at the end of tip 2105. Similarly, by increasing the pressure inside central bore 2102, semiconductor dies 301 can be pushed away from tip 2105.

Several different techniques are possible to attach tip 2105 to shaft 2101. For example, a transition fit or an adhesive such as glue can be used. Alternatively, shaft 2101 and tip 2105 are integrally formed.

Figure 4D illustrates shaft 2101 when no external forces are applied to pickup unit 210, while figure 4C illustrates shaft 2101 when an external force in the x-direction is applied to pickup unit 210. As a result of this force, shaft 2101 is deformed in the x-direction and in the y-direction. More particularly, the length of shaft 2101 in the x-direction is reduced while a width of shaft 2101 in the y-direction is increased.

In figures 4C, 4D, diffraction grating 211 has its elongated pattern units arranged with their longitudinal axes in the x-direction. Consequently, due to the deformation in the y-direction, the effective value for distance d in equations 3 and 4 changes, i.e. it becomes larger. This causes the +1 and -1 order light beams to move away from each other. This change can be detected by sensors 241, 242. More particularly, using the position data from sensors 241, 242, the processor can determine the deformation at the position in diffraction grating 211 where the collimated light beam impinges diffraction grating 211. Using a physical model of pickup unit 210, this deformation can be used for computing a force exerted on tip 2105. This force is related to a counterforce that is exerted on semiconductor die 301.

Although shown as pattern units elongated in the x-direction, diffraction grating 211 could equally use pattern units that are elongated in the y-direction. However, such arrangement would result in the higher order light beams being generated in the x-z plane. In a pick-and-place apparatus, there is generally less space available for arranging the required light source and sensors in this plane than in the z-y plane.

Having established a deformation in pickup unit 210 and/or force exerted on pickup unit 210, the processor may control the drive used for bringing pickup unit 210 and semiconductor 301 into physical contact. For example, when pickup unit 210 is driven by a movable support unit 160 as shown in figure 2, which can be in the form of a linear motor, the processor may control this unit to exert less or more force onto pickup unit 210. This adjustment may be performed while picking up the semiconductor die 301. Alternatively, the adjustment is made in respect of a semiconductor die 301 to be picked up next. In this manner, the force exerted on the semiconductor dies 301 during pick up can be controlled in a uniform manner.

Although described in connection with picking a semiconductor die 301, a similar approach can be used when placing a semiconductor die 301 onto second carrier 302. This generally requires the use of a separate collimated light source and separate sensors. As the components are preferably arranged in the z-y plane, it is preferred that the light sensor emits a collimated light beam in the x-direction onto diffraction grating 211. The sensors for detecting the resulting higher order diffraction beams are then arranged next to the light sensor in the y-direction and the direction opposite to the y-direction. In figure 3, the position of the light source and light sensors for monitoring during component placement are indicated using a circle, and a pair of triangles, respectively.

In the pick-and-place apparatus described in conjunction with figures 3, 4A-4D, a movable support unit was described to move pickup unit 210 in a single direction. The present disclosure is not limited to such movable support unit. In other embodiments, a robotic arm is used on which the pickup unit is mounted.

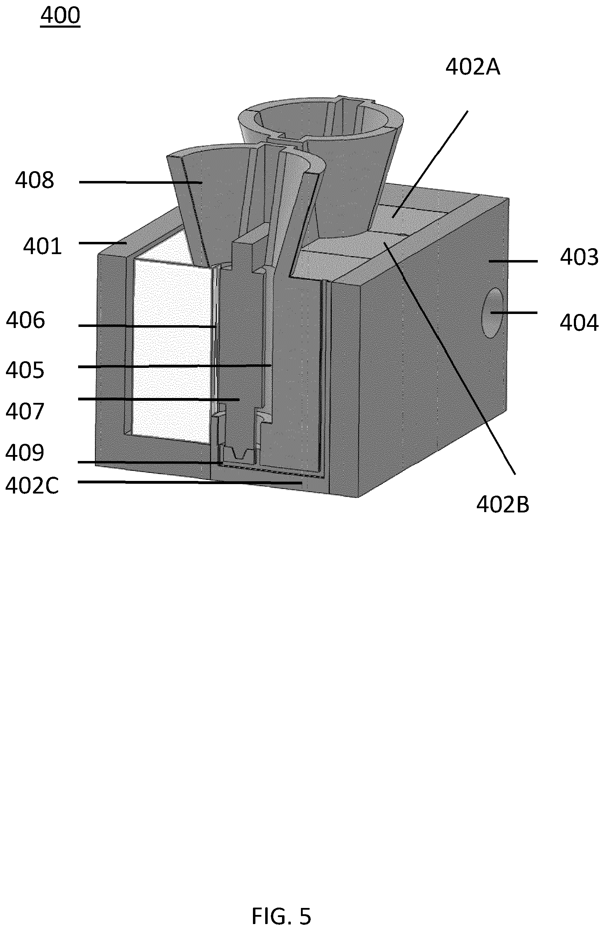

Figure 5 illustrates a mold 400 for making pickup unit 210. Mold 400 comprises a holding box 401 in which several mold parts 402A-402C can be arranged. To this end, holding box 401 may comprise a sealing door 403 that can be fixed to a remainder of holding box 401 using a sealing screw 404. By opening sealing door 403, mold parts 402 can be removed from holding box 401 as well as the at least partially solidified pickup units 210.

Typically, mold parts 402A and 402B are mirrored copies of each other. Furthermore, Mold part 402A and mold part 402C are copies of each other. It is noted that figure 5 does not show the mold part that is complementary to mold part 402C.

An inner wall of mold parts 402A, 402B, 402C defines an outer surface of pickup unit 210. These walls also define a mold cavity 405. Inside mold cavity 405, a diffraction unit 406 is arranged, which comprises a body having an outer surface on which a diffraction grating 211 is provided. Diffraction unit 406 is arranged inside mold cavity 405 such that diffraction grating 211 is facing the inner walls of mold parts 402A, 402B, 402C.

A shaft 407 is arranged in mold cavity, wherein shaft 407 is configured for realizing central bore 2102. Furthermore, at an upper surface, mold parts 402A, 402B, 402C jointly form a pair of pouring cups 408. After closing holding box 401, liquid molding material is poured into pouring cups. Gas inside mold cavity may escape mold cavity through a gas venting channel 409. The molding material can for example comprise one or more resins and/or polymers.

Once at least partially solidified, holding box 401 is opened to allow mold parts 402A-402C, shaft 406, and pickup unit 210 to be removed. Optionally, additional processing can be performed on pickup unit 210 to further cure pickup unit 210.

Using the method described above, a pickup unit 210 is obtained in which diffraction grating 211 is fixedly attached to deformable shaft 210. Other options exist by which a diffraction grating 211 can be formed on or in deformable shaft 210. For example, a pattern corresponding to the inverse of the diffraction grating can be formed on an inner wall of a mold part 402A-402C. In such case, the diffraction grating is formed during the molding process. Other imprinting techniques are possible by which a diffraction grating is pressed into the deformable shaft.

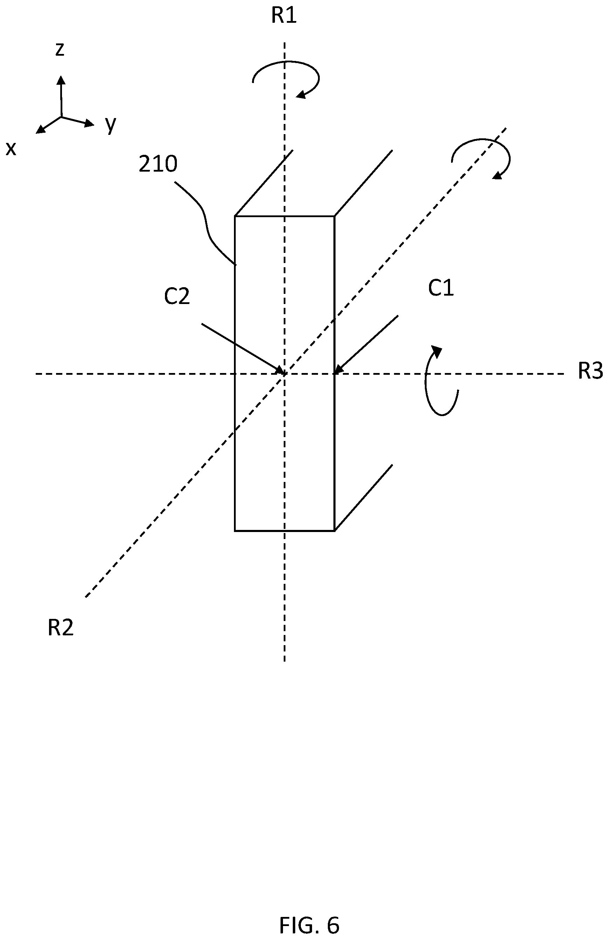

In the description so far, it was assumed that pickup unit 210 has a constant orientation during component pick up and during component placement. Under these conditions, it suffices to measure a single higher order diffraction beam to determine the force or strain on pickup unit 210. However, this assumption may not always hold, in particular because pickup unit 210 may be configured as a moving unit. Mechanical tolerances and clearances may cause pickup unit 210 to display yaw, tilt, and roll as explained in connection with figure 6. In this figure, a diffraction grating is assumed that consists of pattern units that are elongated in the z-direction, and that are repeated in the x-direction. In figure 6, yaw is defined as a rotation about the z-axis, tilt as a rotation about the x-axis, and roll as a rotation about the y-axis.

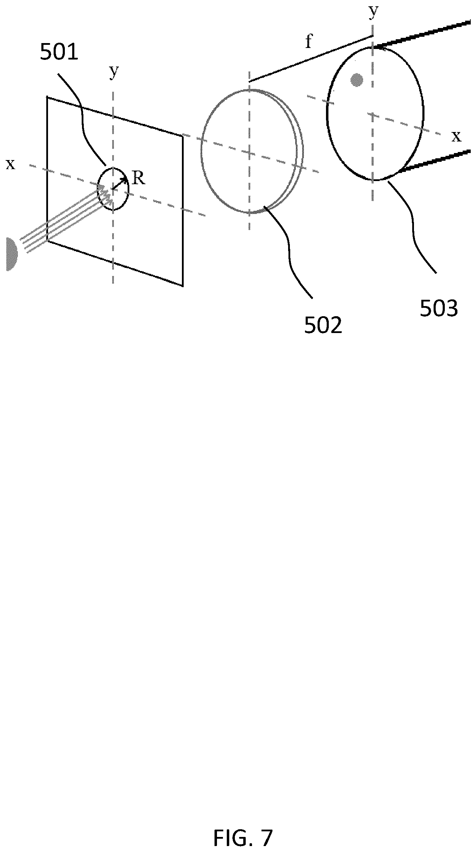

Figure 6 further illustrates a center point C1 of the diffraction grating and a center point C2 of the pickup unit 210 as a whole. Here, it is noted that figure 7 illustrates a cross-sectional view of pickup unit 210 in which a cross-section in the z-y plane is shown halfway the pickup unit 210 in the x-direction.

The method for determining the orientation of pickup unit 210 will now be explained based on three possible assumptions regarding the movement of pickup unit 210.

In a first case, it is assumed that the orientation of pickup unit 210 may change due to yaw, roll, and tilt relative to center point C1 that is fixed in space. In this case, the collimated light source emits a collimated light beam onto center point C1. The higher order light beams created by diffraction are then captured using sensors. More in particular, in this case, two sensors will suffice for uniquely determining the orientation of pickup unit 210. The orientation may correspond to a yaw angle, a tilt angle, and a roll angle.

When two sensors are used, the position data obtained from these sensors comprise 4 independent parameters, e.g. x1, x2, y1, and y2, wherein xn and yn represent the position on a sensor surface at which sensor n detects a higher order diffraction beam. The orientation of pickup unit 210 comprises three degrees of freedom, being the yaw, tilt, and roll angle.

Using position data from two sensors, the processor can determine the orientation of pickup unit 210. To this end, it may use the known position and orientation of the two sensors, for example with respect to center point C1. In addition, the orientation of the light source relative to center point C1 may be known and used by the processor to determine the orientation of pickup unit 210.

In a second case, it is assumed that the orientation of pickup unit 210 may change due to yaw, roll, and tilt relative to center point C2 that is fixed in space. In this case, a positional relationship between center points C1 and C2 is known. This information is used in addition to the previously mentioned information by the processor to determine the orientation of pickup unit 210. Again, three degrees of freedom exist allowing the orientation to be uniquely defined using two sensors.

In a third case, it is assumed that center points C1 and C2 may both change position in space. In this case, six degrees of freedom exist so that additional information is required to determine both position and orientation of pickup unit 210. This additional information can be obtained by using a third sensor that senses the 0-th order diffraction beam. In this case, the processor uses the position data from the first, second, and third sensor for determining the position and orientation of pickup unit 210.

In the second and third cases above, it was assumed that the collimated light source was able to emit a collimated beam of light onto the diffraction grating. To this end, an orientation unit can be provided to change an orientation of the collimated light source. The processor can then be configured to control an orientation of the collimated light source. Furthermore, the processor may implement a feedback control loop in which the orientation of the light source is changed based on a determined position and/or orientation of the device to ensure that the collimated light source keeps emitting collimated light onto the center point of the diffraction grating.

Figure 7 illustrates an advantageous method for determining an angle of a diffraction beam. In this figure, the diffraction beam is passed through a pinhole 501 having a radius R and an objective lens 502 before hitting sensor 503 at a position x, y. A distance between objective lens 502 and sensor 503 corresponds to a focal length f.

It is known that light that passes through a circular aperture is subject to diffraction. More in particular, an Airy pattern is created comprising a central Airy disc that is surrounded by a plurality of concentric circles. The angle at which the first intensity minimum occurs, measured from the direction of the incoming diffraction beam, is approximately given by: $sin θ \approx 1.22 \frac{λ}{2 R}$ Eq. 5 wherein R is the radius of the aperture, which corresponds to the radius of pinhole 501 when light is passed through a pinhole 501, and which corresponds to half the numerical aperture when light is passed through objective lens 502.

When using only a pinhole 501, the diffraction grating on the surface of sensor 503 has a typical Airy patten, i.e. a center bright disc surrounded by a group of bright and dark circles. The size of the Airy disc relies on the distance between pinhole 501 and the sensor surface of sensor 503. When the incident light beam has a weak intensity, only the central bright disc can be observed clearly. The coordinates of the Airy disc on the surface of sensor 503, e.g. x and y, rely on the incident angle of the light beam towards the transverse and vertical direction respectively. When the incident angle changes, even with an expanded beam width due to divergence, the coordinates change accordingly.

When using only objective lens 502, a clear light spot of the Airy disc can be observed on the focal plane. The coordinates of the Airy disc center on the focal plane change according to the changes in the incident angle. It should be noted that in some embodiments, both a pinhole 501 and an objective lens 502 are used.

To calibrate this system, known incident angles and the coordinates of the corresponding Airy disc are first recorded in the x and y directions, respectively, as basic data for calibration. These data may be stored in the form of a lookup table.

In the above, the present invention has been described using detailed embodiments thereof. However, the present invention is not limited to these embodiments. Instead, various modifications are possible without departing from the scope of the present invention which is defined by the appended claims.

## Claims

1. A pick-and-place apparatus (100) for picking an electronic component (301) from a first carrier and for placing the component onto a second carrier (302) comprising a pickup unit (110) for picking up an electronic component and for placing that electronic component, the apparatus further comprising a system for determining an orientation of the pickup unit, said systerm comprising:
a diffraction grating (111, 112) arranged on a surface of the pickup unit;
a collimated light source (121, 122) configured for emitting collimated light onto the diffraction grating thereby creating, by means of diffraction by the diffraction grating, an m-th order light beam and an n-th order light beam, wherein *m* is different from *n,* and wherein *m* and *n* are both integers different from zero;
a first light sensor (143) having a first sensor surface and being configured for detecting the *m*-th order light beam, wherein the first light sensor is configured for detecting a first position on the first sensor surface at which the *m*-th order light beam is detected;
a second light sensor (143) having a second sensor surface and being configured for detecting the n-th order light beam, wherein the second light sensor is configured for detecting a second position on the second sensor surface at which the *n*-th order light beam is detected; and
a processor (150) for determining orientation information concerning an orientation of the pickup unit based on the detected first position and the detected second position.

2. The pick-and-place apparatus according to claim 1, wherein the diffraction grating is at least locally flat and perpendicular to a first direction at a center point of the diffraction grating;
wherein the diffraction grating comprises a repetition of a pattern unit from the center point in a second direction and from the center point in a direction opposite to the second direction; and
wherein the pattern unit at the center point is elongated in a third direction.

3. The pick-and-place apparatus according to claim 2, wherein the collimated light source is configured to emit a collimated beam of light towards the center point of the diffraction grating.

4. The pick-and-place apparatus according to claim 2 or 3, wherein the pickup unit is able to change its orientation by means of:
yawing relative to a yaw rotational axis;
tilting relative to a tilt rotational axis; and
rolling relative to a roll rotational axis;
wherein the orientation information of the pickup unit comprises a yaw angle, a tilt angle, and a roll angle;
wherein preferably, with the pickup unit being oriented in a predetermined default orientation, the yaw rotational axis extends in the third direction, the tilt rotational axis extends in the second direction, and the roll rotational axis extends in the first direction.

5. The pick-and-place apparatus according to claim 4, wherein:
the processor is configured to determine said orientation information based on the assumption that the center point of the diffraction grating remains at a substantially same position in space; or
the processor is configured to determine the orientation of the pickup unit based on the detected first position and the detected second position and a known positional relationship between center point of the diffraction grating and a predetermined center point of the device based on the assumption that the pickup unit moves with the predetermined center point of the pickup unit remaining at a substantially same position in space; or
the system further comprises a third light sensor (143) having a third sensor surface and being configured for detecting an 0-th order light beam, wherein the third light sensor is configured for detecting a third position on the third sensor surface at which the 0-th order light beam is detected, wherein the processor is further configured for determining a position of the pickup unit based on the detected first position, the detected second position, and the detected third position.

6. The pick-and-place apparatus according to claim 5, wherein the processor is configured to control an orientation of the collimated light source, the processor implementing a feedback control loop in which the orientation of the light source is changed based on a determined position and/or orientation of the pickup unit to ensure that the collimated light source keeps emitting collimated light onto the center point of the diffraction grating.

7. The pick-and-place apparatus according to any of the previous claims, wherein *m=-n,* and wherein *m* is preferably equal to 1.

8. The pick-and-place apparatus according to any of the previous claims, wherein the first and second sensors, and if applicable the third sensor, have a fixed and known position and orientation.

9. The pick-and-place apparatus according to any of the previous claims, wherein the collimated light source is a coherent light source, such as a laser.

10. The pick-and-place apparatus according to any of the previous claims, further comprising a memory that is operatively coupled to the processor, said memory comprising a lookup table comprising data that correlates position data obtained from the first, second, and optionally third sensor, to orientation and/or position information of the pickup unit.

11. The pick-and-place apparatus according to any of the previous claims, wherein the first sensor, second sensor, and optionally third sensor are substantially flat sensors.

12. The pick-and-place apparatus according to any of the claims 1-10, wherein the first sensor, second sensor, and optionally third sensor are curved sensors of which each point on the corresponding sensor surface has a substantially identical distance to a common reference point, and in so far as depending on claim 5, the common reference point substantially coinciding with the center point of the diffraction grating;
wherein the first sensor, second sensor, and optionally third sensor are different parts of a single integral sensor.

13. The pick-and-place apparatus according to any of the previous claims, wherein the grating is a reflective grating or a transmissive grating.

14. A method for determining an orientation of a pickup unit (110) of a pick and place apparatus (100) for picking an electronic component (301) from a first carrier and for placing the electronic component onto a second carrier (302), wherein a surface of the pickup unit is provided with a diffraction grating (111, 112) the method comprising:
emitting collimated light onto the diffraction grating thereby creating, by means of diffraction by the diffraction grating, an *m*-th order light beam and an n-th order light beam, wherein *m* is different from *n,* and wherein *m* and *n* are both integers different than zero;
detecting, using a first light sensor (143) having a first sensor surface, the m-th order light beam, said detecting comprising detecting a first position on the first sensor surface at which the m-th order light beam is detected;
detecting, using a second light sensor (143) having a second sensor surface, the *n*-th order light beam, said detecting comprising detecting a second position on the second sensor surface at which the n-th order light beam is detected; and
determining, using a processor (150), an orientation of the pickup unit based on the detected first position and the detected second position.

## Patentansprüche

1. Aufnahme- und Platzierungsvorrichtung (100) zum Aufnehmen einer elektronischen Komponente (301) von einem ersten Träger und zum Platzieren der Komponente auf einem zweiten Träger (302), umfassend eine Aufnahmeeinheit (110) zum Aufnehmen einer elektronischen Komponenten und zum Platzieren dieser elektronischen Komponente, wobei die Vorrichtung ferner ein System zum Bestimmen einer Ausrichtung der Aufnahmeeinheit umfasst, wobei das System Folgendes umfasst:
ein Beugungsgitter (111, 112), das auf einer Oberfläche der Aufnahmeeinheit angeordnet ist;
eine Quelle (121, 122) für kollimiertes Licht, die zum Emittieren von kollimiertem Licht auf das Beugungsgitter konfiguriert ist, wodurch mittels Beugung durch das Beugungsgitter ein Lichtstrahl *m*. Ordnung und ein Lichtstrahls *n*. Ordnung erzeugt wird, wobei sich *m* von *n* unterscheidet und wobei sowohl m als auch n ganze Zahlen sind, die sich von 0 unterscheiden;
einen ersten Lichtsensor (143), der eine erste Sensorfläche aufweist und zum Erkennen des Lichtstrahls *m*. Ordnung konfiguriert ist, wobei der erste Lichtsensor zum Erkennen einer ersten Position auf der ersten Sensorfläche, an der der Lichtstrahl *m*. Ordnung erkannt wird, konfiguriert ist;
einen zweiten Lichtsensor (143), der eine zweite Sensorfläche aufweist und zum Erkennen des Lichtstrahls *n*. Ordnung konfiguriert ist, wobei der zweite Lichtsensor zum Erkennen einer zweiten Position auf der zweiten Sensorfläche, an der der Lichtstrahl *n*. Ordnung erkannt wird, konfiguriert ist; und
einen Prozessor (150) zum Bestimmen von Ausrichtungsinformationen, die eine Ausrichtung der Aufnahmeeinheit betreffen, basierend auf der erkannten ersten Position und der erkannten zweiten Position.

2. Aufnahme- und Platzierungsvorrichtung nach Anspruch 1, wobei das Beugungsgitter zumindest lokal eben ist und an einem Mittelpunkt des Beugungsgitters senkrecht zu einer ersten Richtung liegt;
wobei das Beugungsgitter von dem Mittelpunkt aus in einer zweiten Richtung und von dem Mittelpunkt aus in einer Richtung, die der zweiten Richtung entgegengesetzt ist, eine Wiederholung einer Mustereinheit umfasst; und
wobei die Mustereinheit an dem Mittelpunkt in einer dritten Richtung gestreckt ist.

3. Aufnahme- und Platzierungsvorrichtung nach Anspruch 2, wobei die Quelle für kollimiertes Licht dafür konfiguriert ist, einen kollimierten Strahl Lichts zu dem Mittelpunkt des Beugungsgitters hin zu emittieren.

4. Aufnahme- und Platzierungsvorrichtung nach Anspruch 2 oder 3, wobei die Aufnahmeeinheit in der Lage ist, ihre Ausrichtung mittels des Folgenden zu ändern:
Gieren relativ zu einer Gierdrehachse;
Neigen relativ zu einer Neigungsdrehachse; und
Rollen relativ zu einer Rolldrehachse;
wobei die Ausrichtungsinformationen der Aufnahmeeinheit einen Gierwinkel, einen Neigungswinkel und einen Rollwinkel umfassen;
wobei sich vorzugsweise, wenn die Aufnahmeeinheit in einer festgelegten Standardausrichtung ausgerichtet ist, die Gierdrehachse in der dritten Richtung erstreckt, sich die Neigungsdrehachse in der zweiten Richtung erstreckt und sich die Rolldrehachse in der ersten Richtung erstreckt.

5. Aufnahme- und Platzierungsvorrichtung nach Anspruch 4, wobei:
der Prozessor dafür konfiguriert ist, die Ausrichtungsinformationen basierend auf der Annahme zu bestimmen, dass der Mittelpunkt des Beugungsgitters an einer im Wesentlichen gleichen Position im Raum bleibt; oder
der Prozessor dafür konfiguriert ist, die Ausrichtung der Aufnahmeeinheit basierend auf der erkannten ersten Position und der erkannten zweiten Position und einem bekannten Positionsverhältnis zwischen dem Mittelpunkt des Beugungsgitters und einem festgelegten Mittelpunkt des Bauelements basierend auf der Annahme zu bestimmen, dass sich die Aufnahmeeinheit bewegt, während der festgelegte Mittelpunkt der Aufnahmeeinheit an einer im Wesentlichen gleichen Position im Raum bleibt; oder
das System ferner einen dritten Lichtsensor (143) umfasst, der eine dritte Sensorfläche aufweist und zum Erkennen eines Lichtstrahls 0. Ordnung konfiguriert ist, wobei der dritte Lichtsensor zum Erkennen einer dritten Position auf der dritten Sensorfläche, an der der Lichtstrahl 0. Ordnung erkannt wird, konfiguriert ist, wobei der Prozessor ferner zum Bestimmen einer Position der Aufnahmeeinheit basierend auf der erkannten ersten Position, der erkannten zweiten Position und der erkannten dritten Position konfiguriert ist.

6. Aufnahme- und Platzierungsvorrichtung nach Anspruch 5, wobei der Prozessor dafür konfiguriert ist, eine Ausrichtung der Quelle für kollimiertes Licht zu steuern, wobei der Prozessor einen Rückkopplungsregelkreis implementiert, in dem die Ausrichtung der Lichtquelle basierend auf einer bestimmten Position und/oder Ausrichtung der Aufnahmeeinheit verändert wird, um zu gewährleisten, dass die Quelle für kollimiertes Licht weiterhin kollimiertes Licht auf den Mittelpunkt des Beugungsgitters emittiert.

7. Aufnahme- und Platzierungsvorrichtung nach einem der vorhergehenden Ansprüche, wobei *m* = -*n* und wobei *m* vorzugsweise gleich 1 ist.

8. Aufnahme- und Platzierungsvorrichtung nach einem der vorhergehenden Ansprüche, wobei der erste und der zweite Sensor und, falls anwendbar, der dritte Sensor eine feste und bekannte Position und Ausrichtung aufweisen.

9. Aufnahme- und Platzierungsvorrichtung nach einem der vorhergehenden Ansprüche, wobei die Quelle für kollimiertes Licht eine Quelle für kohärentes Licht ist, wie beispielsweise ein Laser.

10. Aufnahme- und Platzierungsvorrichtung nach einem der vorhergehenden Ansprüche, ferner umfassend einen Speicher, der funktionsmäßig mit dem Prozessor gekoppelt ist, wobei der Speicher eine Nachschlagetabelle umfasst, die Daten umfasst, die Positionsdaten, die von dem ersten, dem zweiten und optional dem dritten Sensor erhalten werden, zu Ausrichtungs- und/oder Positionsinformationen der Aufnahmeeinheit in Beziehung setzt.

11. Aufnahme- und Platzierungsvorrichtung nach einem der vorhergehenden Ansprüche, wobei der erste Sensor, der zweite Sensor und optional der dritte Sensor im Wesentlichen ebene Sensoren sind.

12. Aufnahme- und Platzierungsvorrichtung nach einem der Ansprüche 1 bis 10, wobei der erste Sensor, der zweite Sensor und optional der dritte Sensor gekrümmte Sensoren sind, von denen jeder Punkt auf der entsprechenden Sensorfläche einen im Wesentlichen identischen Abstand zu einem gemeinsamen Referenzpunkt aufweist, und sofern abhängig von Anspruch 5, der gemeinsame Referenzpunkt im Wesentlichen mit dem Mittelpunkt des Beugungsgitters zusammenfällt;
wobei der erste Sensor, der zweite Sensor und optional der dritte Sensor verschiedene Teile eines einzigen integralen Sensors sind.

13. Aufnahme- und Platzierungsvorrichtung nach einem der vorhergehenden Ansprüche, wobei das Gitter ein reflektierendes Gitter oder ein transmissives Gitter ist.

14. Verfahren zum Bestimmen einer Ausrichtung einer Aufnahmeeinheit (110) einer Aufnahme- und Platzierungsvorrichtung (100) zum Aufnehmen einer elektronischen Komponente (301) von einem ersten Träger und zum Platzieren der elektronischen Komponente auf einem zweiten Träger (302), wobei eine Fläche der Aufnahmeeinheit mit einem Beugungsgitter (111, 112) versehen ist, wobei das Verfahren Folgendes umfasst:
Emittieren von kollimiertem Licht auf das Beugungsgitter, wodurch mittels Beugung durch das Beugungsgitter ein Lichtstrahl *m*. Ordnung und ein Lichtstrahl *n*. Ordnung erzeugt wird, wobei sich *m* von *n* unterscheidet und wobei sowohl *m* als auch *n* ganze Zahlen sind, die sich von 0 unterscheiden;
Erkennen des Lichtstrahls *m*. Ordnung unter Verwendung eines ersten Lichtsensors (143), der eine erste Sensorfläche aufweist, wobei das Erkennen das Erkennen einer ersten Position auf der ersten Sensorfläche, an der der Lichtstrahl *m*. Ordnung erkannt wird, umfasst;
Erkennen des Lichtstrahls *n*. Ordnung unter Verwendung eines zweiten Lichtsensors (143), der eine zweite Sensorfläche aufweist, wobei das Erkennen das Erkennen einer zweiten Position auf der zweiten Sensorfläche, an der der Lichtstrahl *n*. Ordnung erkannt wird, umfasst; und
Bestimmen einer Ausrichtung der Aufnahmeeinheit unter Verwendung eines Prozessors (150) basierend auf der erkannten ersten Position und der erkannten zweiten Position.

## Revendications

1. Machine de préhension et de positionnement (100) pour appréhender un composant électronique (301) à partir d'un premier support et pour positionner le composant sur un deuxième support (302), comprenant une unité de préhension (110) pour appréhender un composant électronique et pour positionner ce composant électronique, la machine comprenant en outre un système pour déterminer une orientation de l'unité de préhension, ledit système comprenant :
un réseau de diffraction (111, 112) agencé sur une surface de l'unité de préhension ;
une source de lumière collimatée (121, 122) configurée pour émettre de la lumière collimatée sur le réseau de diffraction, créant ainsi, au moyen d'une diffraction par le réseau de diffraction, un faisceau lumineux d'ordre *m* et un faisceau lumineux d'ordre *n*, dans lequel *m* est différent de *n*, et dans lequel *m* et *n* sont tous deux des nombres entiers différents de zéro ;
un premier capteur de lumière (143) ayant une première surface de capteur et étant configuré pour détecter le faisceau lumineux d'ordre *m*, dans lequel le premier capteur de lumière est configuré pour détecter une première position sur la première surface de capteur au niveau de laquelle le faisceau lumineux d'ordre *m* est détecté ;
un deuxième capteur de lumière (143) ayant une deuxième surface de capteur et étant configuré pour détecter le faisceau lumineux d'ordre *n*, dans lequel le deuxième capteur de lumière est configuré pour détecter une deuxième position sur la deuxième surface de capteur au niveau de laquelle le faisceau lumineux d'ordre *n* est détecté ; et
un processeur (150) pour déterminer des informations d'orientation concernant une orientation de l'unité de préhension à partir de la première position détectée et de la deuxième position détectée.

2. Machine de préhension et de positionnement selon la revendication 1, dans laquelle le réseau de diffraction est au moins localement plat et perpendiculaire à une première direction au niveau d'un point central du réseau de diffraction ;
dans laquelle le réseau de diffraction comprend une répétition d'une unité de motif à partir du point central dans une deuxième direction et à partir du point central dans une direction opposée à la deuxième direction ; et
dans laquelle l'unité de motif au niveau du point central est allongée dans une troisième direction.

3. Machine de préhension et de positionnement selon la revendication 2, dans laquelle la source de lumière collimatée est configurée pour émettre un faisceau collimaté de lumière vers le point central du réseau de diffraction.

4. Machine de préhension et de positionnement selon la revendication 2 ou 3, dans laquelle l'unité de préhension est capable de modifier son orientation au moyen :
d'un lacet par rapport à un axe de rotation de lacet ;
d'une inclinaison par rapport à un axe de rotation d'inclinaison ; et
d'un roulis par rapport à un axe de rotation de roulis ;
dans laquelle les informations d'orientation de l'unité de préhension comprennent un angle de lacet, un angle d'inclinaison, et un angle de roulis ;
dans laquelle, de préférence, l'unité de préhension étant orientée dans une orientation par défaut prédéterminée, l'axe de rotation de lacet s'étend dans la troisième direction, l'axe de rotation d'inclinaison s'étend dans la deuxième direction, et l'axe de rotation de roulis s'étend dans la première direction.

5. Machine de préhension et de positionnement selon la revendication 4, dans laquelle :
le processeur est configuré pour déterminer lesdites informations d'orientation à partir de l'hypothèse selon laquelle le point central du réseau de diffraction reste à une position sensiblement identique dans l'espace ; ou
le processeur est configuré pour déterminer l'orientation de l'unité de préhension à partir de la première position détectée et de la deuxième position détectée et d'une relation de position connue entre le point central du réseau de diffraction et un point central prédéterminé du dispositif à partir de l'hypothèse selon laquelle l'unité de préhension se déplace avec le point central prédéterminé de l'unité de préhension restant à une position sensiblement identique dans l'espace ; ou
le système comprend en outre un troisième capteur de lumière (143) ayant une troisième surface de capteur et étant configuré pour détecter un faisceau lumineux d'ordre 0, dans lequel le troisième capteur de lumière est configuré pour détecter une troisième position sur la troisième surface de capteur au niveau de laquelle le faisceau lumineux d'ordre 0 est détecté, dans lequel le processeur est en outre configuré pour déterminer une position de l'unité de préhension à partir de la première position détectée, de la deuxième position détectée, et de la troisième position détectée.

6. Machine de préhension et de positionnement selon la revendication 5, dans laquelle le processeur est configuré pour commander une orientation de la source de lumière collimatée, le processeur mettant en œuvre une boucle de commande à rétroaction dans laquelle l'orientation de la source de lumière est modifiée à partir d'une position et/ou d'une orientation déterminée de l'unité de préhension pour garantir que la source de lumière collimatée continue à émettre de la lumière collimatée sur le point central du réseau de diffraction.

7. Machine de préhension et de positionnement selon l'une quelconque des revendications précédentes, dans laquelle *m* = -*n*, et dans laquelle *m* est de préférence égal à 1.

8. Machine de préhension et de positionnement selon l'une quelconque des revendications précédentes, dans laquelle les premier et deuxième capteurs, et le cas échéant le troisième capteur, ont une position et une orientation fixes et connues.

9. Machine de préhension et de positionnement selon l'une quelconque des revendications précédentes, dans laquelle la source de lumière collimatée est une source de lumière cohérente, telle qu'un laser.

10. Machine de préhension et de positionnement selon l'une quelconque des revendications précédentes, comprenant en outre une mémoire qui est couplée de manière fonctionnelle au processeur, ladite mémoire comprenant une table de correspondance comprenant des données qui corrèlent des données de position obtenues à partir des premier, deuxième, et fonctionnellement troisième capteurs, à des informations d'orientation et/ou de position de l'unité de préhension.

11. Machine de préhension et de positionnement selon l'une quelconque des revendications précédentes, dans laquelle le premier capteur, le deuxième capteur, et fonctionnellement le troisième capteur sont des capteurs sensiblement plats.

12. Machine de préhension et de positionnement selon l'une quelconque des revendications 1 à 10, dans laquelle le premier capteur, le deuxième capteur, et fonctionnellement le troisième capteur sont des capteurs incurvés dont chaque point sur la surface de capteur correspondante présente une distance sensiblement identique par rapport à un point de référence commun, et pour autant qu'elle dépende de la revendication 5, le point de référence commun coïncidant sensiblement avec le point central du réseau de diffraction ;
dans laquelle le premier capteur, le deuxième capteur, et fonctionnellement le troisième capteur sont des parties différentes d'un seul capteur intégré.

13. Machine de préhension et de positionnement selon l'une quelconque des revendications précédentes, dans laquelle le réseau est un réseau réfléchissant ou un réseau transmissif.

14. Procédé pour déterminer une orientation d'une unité de préhension (110) d'une machine de préhension et de positionnement (100) pour appréhender un composant électronique (301) à partir d'un premier support et pour positionner le composant électronique sur un deuxième support (302), dans lequel une surface de l'unité de préhension est munie d'un réseau de diffraction (111, 112), le procédé comprenant :
l'émission de lumière collimatée sur le réseau de diffraction, créant ainsi, au moyen d'une diffraction par le réseau de diffraction, un faisceau lumineux d'ordre *m* et un faisceau lumineux d'ordre *n*, dans lequel *m* est différent de *n*, et dans lequel *m* et *n* sont tous deux des nombres entiers différents de zéro ;
la détection, à l'aide d'un premier capteur de lumière (143) ayant une première surface de capteur, du faisceau lumineux d'ordre *m*, ladite détection comprenant la détection d'une première position sur la première surface de capteur au niveau de laquelle le faisceau lumineux d'ordre *m* est détecté ;
la détection, à l'aide d'un deuxième capteur de lumière (143) ayant une deuxième surface de capteur, du faisceau lumineux d'ordre *n*, ladite détection comprenant la détection d'une deuxième position sur la deuxième surface de capteur au niveau de laquelle le faisceau lumineux d'ordre *n* est détecté ; et
la détermination, à l'aide d'un processeur (150), d'une orientation de l'unité de préhension à partir de la première position détectée et de la deuxième position détectée.
